Europäisches Patentamt

European Patent Office

Office européen des brevets

(19)

(11) **EP 0 583 186 B1**

(12) **FASCICULE DE BREVET EUROPEEN**

(45) Date de publication et mention
de la délivrance du brevet:
**18.09.1996 Bulletin 1996/38**

(51) Int Cl.⁶: **H01S 3/133**, H01S 3/096, G05F 1/00

(21) Numéro de dépôt: **93401910.0**

(22) Date de dépôt: **22.07.1993**

(54) **Dispositif de contrôle de la puissance de sortie des diodes laser**

Vorrichtung zur Leistungsstabilisierung von Laserdioden

Control unit for stabilising the ouput power of laser diodes

(84) Etats contractants désignés:
**DE GB**

(30) Priorité: **30.07.1992 FR 9209487**

(43) Date de publication de la demande:
**16.02.1994 Bulletin 1994/07**

(73) Titulaire: **FRANCE TELECOM**
**75015 Paris (FR)**

(72) Inventeurs:
- **Queniat, Jean-François**
  **F-75116 Paris (FR)**
- **Jaillard, André**
  **F-75116 Paris (FR)**

(74) Mandataire: **Ballot, Paul Denis Jacques**
**Cabinet Ballot-Schmit,**
**7, rue Le Sueur**
**75116 Paris (FR)**

(56) Documents cités:
EP-A- 0 061 034          EP-A- 0 396 371
EP-A- 0 421 674          EP-A- 0 497 431
WO-A-92/05608           US-A- 4 995 105

- PATENT ABSTRACTS OF JAPAN vol. 14, no. 365 (E-961)8 Aoüt 1990 & JP-A-02 130 885 (SEIKO EPSON CORP)
- PATENT ABSTRACTS OF JAPAN vol. 8, no. 149 (E-255)12 Juillet 1984 & JP-A-59 054 280 (FUJITSU KK)
- PATENT ABSTRACTS OF JAPAN vol. 1, no. 117 (E-400)2 Mai 1986 & JP-A-60 251 731 (FUJITSU KK)
- PATENT ABSTRACTS OF JAPAN vol. 13, no. 383 (E-811)24 Aoüt 1989 & JP-A-01 133 384 (MATSUSHITA ELECTRIC IND CO)
- Patent Abstracts of Japan, vol.11, no.198 (E-519) 25/06/1987 &US-A-4 747 091

**Description**

L'invention concerne un dispositif de contrôle de la puissance de sortie des diodes laser susceptibles d'être couplées à une fibre optique pour la transmission de signaux numériques sur fibres optiques.

Les diodes laser sont largement utilisées dans le domaine des transmissions numériques sur fibres optiques, mais ont l'inconvénient de présenter des variations importantes de la puissance lumineuse émise en réponse à un changement de la température ou à un vieillissement de la diode.

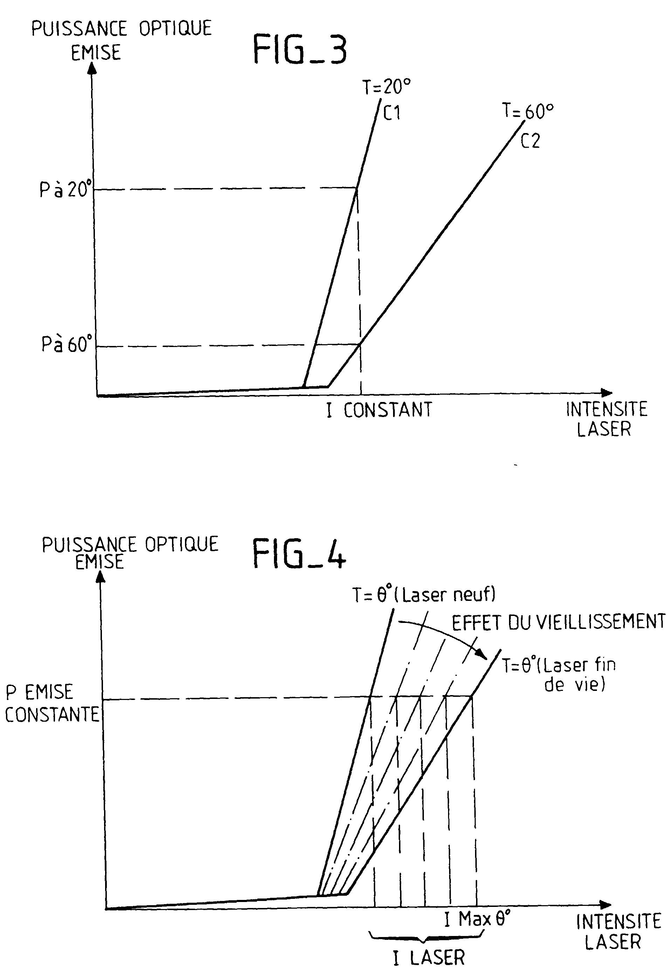

On peut se reporter au schéma des figures 3 et 4 pour mieux comprendre ces phénomènes.

Sur la figure 3 on a représenté les variations de la courbe caractéristique d'un laser en fonction de la température. Pour une température T = 20°C on obtient la courbe C1 et pour une température T = 60°C on obtient la courbe C2. On remarque ainsi, que pour un courant d'alimentation I constant la puissance optique émise est supérieure lorsque la température est égale à 20°C à celle qui est émise lorsque la température est égale à 60°C.

La figure 4 représente deux courbes caractéristiques de diodes laser dont l'une correspond à un laser neuf et l'autre correspondant à un laser en fin de vie. Ces courbes caractéristiques ont été relevées pour une température constante égale à $\Theta$°C.

On remarque également sur cette figure 4 que la puissance optique émise est plus faible pour un courant I donné lorsque le laser est en fin de vie.

Il existe une méthode de régulation permettant de compenser les variations de la puissance de sortie émise par la diode laser dues à une variation de la température. Cette méthode consiste à réaliser une régulation analogique de la puissance lumineuse émise par une diode laser en comparant un signal représentatif de ladite puissance à un signal de référence pour obtenir un signal d'erreur qui est utilisé pour modifier le courant électrique d'alimentation de la diode laser.

On a remarqué que cette méthode présentait l'inconvénient d'être très peu efficace lorsque l'émission des données est périodique. En effet, la boucle qui réalise une régulation en continu est prise en défaut car elle utilise comme signal représentatif, un signal représentatif de la puissance émise sporadique.

Une autre méthode connue consiste uniquement à réguler en température. La régulation est effectuée par refroidissement à l'aide d'un élément actif tel qu'un élément à effet Peltier commandé par une boucle de contre-réaction dont le signal d'entrée est constitué par l'écart entre la température mesurée du laser et une température de consigne. Cet asservissement a l'inconvénient d'être coûteux et de consommer beaucoup d'énergie et de ne pas tenir compte de la dérive due au vieillissement du laser.

Il existe également des systèmes qui prévoient la fin de vie de la diode laser. Ces systèmes comportent une régulation pour pallier les effets de variation dus au vieillissement de la diode et également un élément actif pour maintenir constante la température de fonctionnement. Ainsi le courant I maximum indiquant la fin de vie du laser prend une valeur fixe, dépendant de la température de fonctionnement maintenue constante. Le diagnostic se réduit alors à une simple comparaison de la valeur du courant d'alimentation du laser et de celle du courant Imax préalablement fixée. Un tel système rudimentaire reste coûteux et consomme beaucoup d'énergie.

Outre ces inconvénients, le déposant a également constaté que ce produisait une perte de puissance optique due au couplage de la diode laser sur la fibre optique et qu'aucun système, à l'heure actuelle ne permettait parfaitement de maîtriser ce phénomène. Elle a également constaté que l'élément qui permettait de récupérer l'image de l'information, qui était, en général, une photodiode en face arrière du laser, était légèrement perturbé par un changement de température et que, de ce fait, le signal représentatif de la puissance lumineuse émise était également soumis à des variations dues aux variations de température. Aucun système de régulation existant ne permet, de prendre en compte ce phénomène.

On pourra se reporter à l'état de la technique considéré comme le plus proche et constitué par le document D1 : WO-A-92 05 608.

Ce courant décrit un dispositif selon le préambule de la revendication 1. Ce dispositif permet d'effectuer une calibration périodique de la diode pour trouver le meilleur point de fonctionnement.

La présente invention a pour but de remédier à l'ensemble de ces problèmes.

La présente invention a plus particulièrement pour objet un dispositif de contrôle de la puissance de sortie d'une diode laser susceptible d'être couplée à une fibre optique, tel que revendiqué dans la revendication 1.

Le dispositif comporte:

- une photodiode permettant d'acquérir un signal caractéristique de la puissance émise par la diode laser ;
- des moyens numériques de pilotage de la diode laser;
- des moyens de mémorisation de programme ;
- des moyens de mémorisation de paramètres ;
- un canal de communication.

Le dispositif comporte éventuellement un capteur de température. Les moyens numériques de pilotage de la diode sont aptes à recevoir et à traiter le signal caractéristique pour fournir un signal de commande en courant de manière à maintenir une puissance lumineuse de sortie de la diode laser constante, ces moyens comportant une unité centrale de traitement associés à des moyens de mémorisation de programme de calcul d'asservissement, maintenant une puissance de sortie constante, quels que soient la dérive et le changement de pente de la caractéristique de la diode laser en réponse aux vieillissements ou à un changement de température ou à une perte de puissance due au couplage de cette diode à une fibre optique ou au variations de la réponse de la photodiode en fonction de la température.

Les moyens de mémorisation de programme sont également chargés d'un programme de gestion d'alarme permettant de déclencher des alarmes dès détection d'une anomalie de fonctionnement. Les moyens de mémorisation de paramètres sont chargés de paramètres caractéristiques de la diode laser, de paramètres alarme et de paramètres de couplage de fibre préalablement déterminés.

Le canal de communication permet à l'unité de traitement d'émettre et/ou de recevoir des informations vers/ou d'un centre de gestion.

Selon un autre aspect de l'invention, le dispositif peut être réalisé sous la forme d'un composant dans lequel les moyens de pilotage sont formés par une seule puce de circuit intégré sur un substrat suivant une technologie bi-CMOS.

Selon un autre aspect de l'invention, le dispositif peut être réalisé sous la forme d'un composant hybride dans lequel les moyens de pilotage, la diode laser et la photodiode sont formés par des puces de circuit intégré sur des substrats distincts.

D'autres particularités et avantages de l'invention apparaîtront clairement dans la description suivante faite à titre d'exemple non limitatif en regard des figures annexées qui représentent :

- la figure 1, le schéma du dispositif selon un premier mode de réalisation ;
- la figure 2, le schéma du dispositif selon un deuxième mode de réalisation ;
- la figure 3, deux courbes de réponse d'une diode laser en fonction des variations de la température;
- la figure 4, deux courbes réponse d'une diode laser en début de vie et en fin de vie ;
- la figure 5, des courbes réponse d'une diode laser en fonction des variations de la température et de la photodiode fournissant le signal caractéristique de la puissance émise par la diode laser, également en fonction des variations de la température ;
- la figure 6, représente un schéma fonctionnel du dispositif conforme à l'invention ;
- les figures 7 et 8 représentent un chronogramme illustrant le mode de transmission à l'alternat entre un système A et un système B ;
- la figure 9 représente le diagramme structurel du calcul d'asservissement conforme à l'invention;
- la figure 10, permet d'illustrer les écarts de puissance en fonction de la température sur la courbe réponse d'une diode laser.
- la figure 11, un exemple de réalisation du circuit 150;
- la figure 12, un exemple de réalisation du circuit 158;
- la figure 13, un exemple de réalisation du circuit 162.

Le dispositif de contrôle de la puissance de sortie des diodes laser susceptibles d'être couplées à une fibre optique peut être réalisé comme cela a déjà été mentionné sous la forme d'un composant monochip ou hybride selon le cas.

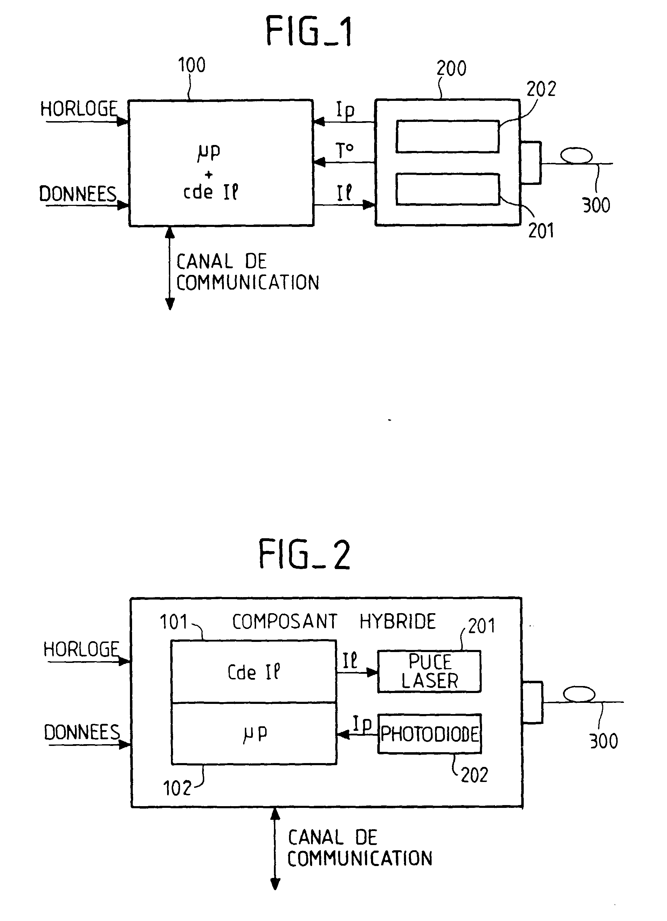

La figure 1 illustre un composant monochip. le composant comporte des moyens numériques de pilotage réalisés à l'aide d'un coeur de microprocesseur et de périphériques tels que des convertisseurs analogiques-numériques-analogiques, un capteur de température, des mémoires de type ROM, Flash EPROM ou EEPROM et une commande en courant pour la tête laser.

Le composant monochip portant la référence 100 sur la figure 1 sera donc apte à réaliser la fonction de pilotage numérique d'une tête laser montée dans un composant hybride 200. Le composant comporte une entrée pour recevoir un signal d'horloge, une entrée de données d'émission, une entrée pour recevoir un signal caractéristique de la puissance émise par la tête laser, une entrée pour recevoir la température régnant autour de la tête laser, une sortie correspondant au courant de modulation de la tête laser et une interface vers un canal de communication permettant à un système d'exploitation ou de surveillance d'être relié via ce canal de communication aux composants et d'assurer une surveillance du composant et éventuellement d'aller modifier des paramètres enregistrés en mémoire non volatiles électriquement effaçables.

La figure 2 correspond au schéma de principe d'une variante de réalisation d'un tel dispositif consistant à regrouper dans un composant de type hybride un microprocesseur 102, une commande en courant 101, la puce laser 201 et la photodiode 202. Le composant a également une entrée d'horloge, une entrée de données et une liaison avec un canal de commutation. Bien entendu, dans les deux variantes, des moyens de couplage classiques en soi permettent de coupler une fibre optique 300 à la puce laser de manière à ce que la puissance émise par la tête laser soit transmise par la fibre.

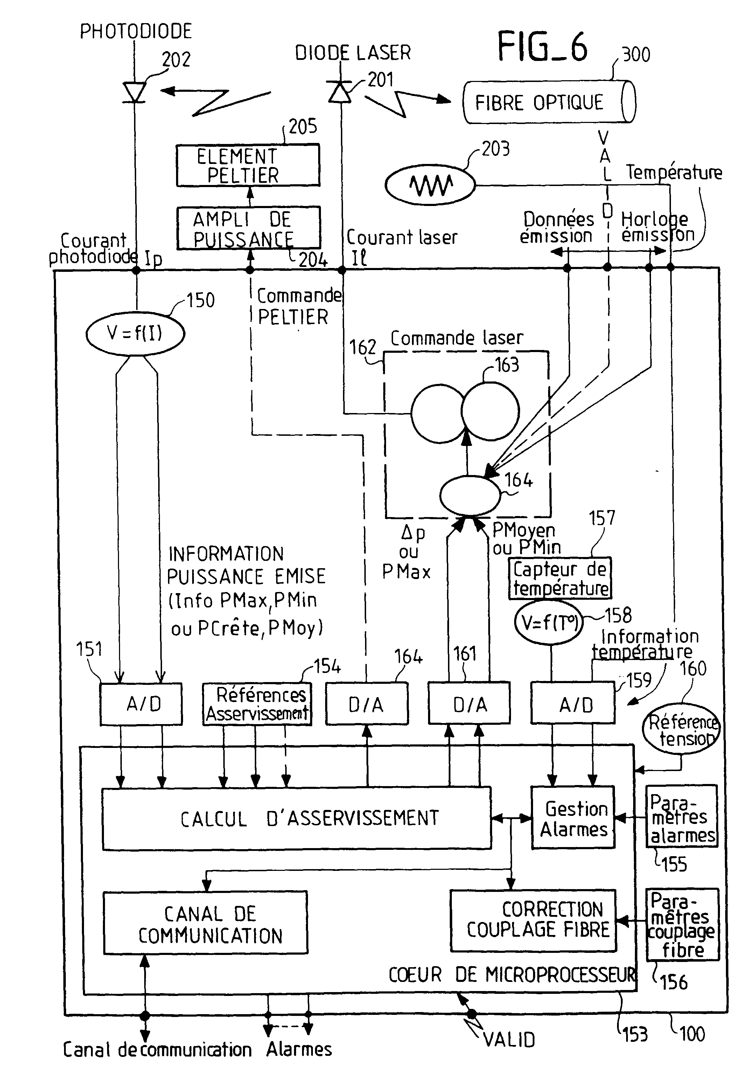

Le schéma de la figure 6 représente un schéma fonctionnel du dispositif conforme à l'invention. Le composant 100 permet de fournir une commande en courant à la diode laser 201, qui émet des signaux sur la fibre optique 300 à puissance constante, sous le contrôle du composant.

La photodiode permet de fournir un courant au composant, courant qui est caractéristique de la puissance émise par la diode laser.

Un circuit 150 permet d'obtenir une fonction V=f(I) de manière à obtenir à partir du courant IP deux informations de puissance émise, à savoir la puissance maximale et la puissance minimale ou la puissance crête et la puissance moyenne. On parlera dans le reste de la description de PMax, PMin pour respectivement la puissance maximale et la puissance minimale et de PCrête, PMoy pour respectivement la puissance crête et la puissance moyenne. Ces deux informations sont appliquées aux entrées d'un convertisseur analogique/numérique 151 qui les transmet, après numérisation au microprocesseur 153. Le microprocesseur reçoit, d'autre part, un ensemble de paramètres et en particulier des paramètres d'asservissement, des paramètres alarme et des paramètres de couplage de fibres provenant respectivement, de zones mémoire 154, 155 et 156 d'une mémoire de type EEPROM ou Flash EPROM.

Un capteur de température 157 est prévu afin de fournir une information sur la température ambiante. Cette information étant transformée par un circuit 158 qui permet de réaliser la fonction V=f(T) c'est à dire d'obtenir une tension fonction de la température. Cette tension est appliquée à l'entrée d'un convertisseur analogique numérique 159 qui transmet le signal de température numérisé au microprocesseur 153. Cette fonction est active quand la diode laser et le circuit de commande sont situés dans un même composant hybride. Ce même convertisseur peut également recevoir par l'intermédiaire d'une entrée du circuit 100 une autre information de température, température de l'extérieur qui peut être fournie par un capteur de température 203 placé à proximité de la diode laser. Cette fonction est active quand la diode laser et le circuit de commande sont situés dans deux composants distincts.

Il est également prévu un circuit 160 permettant de fournir une référence tension aux divers convertisseurs analogiques numériques, ce circuit pouvant être réalisé d'une manière tout à fait classique en soi.

Le microprocesseur 153 et les différents programmes réalisant le calcul d'asservissement, la gestion des alarmes, la correction de couplage fibre, chargés dans une mémoire ROM ou EEPROM ou Flash EPROM permettent de fournir des signaux de réglage des niveaux de courant maximum et minimum du courant laser et du niveau moyen de ce courant.

Le microprocesseur 153 fournit deux informations de puissance à émettre. Ces informations peuvent être soit les puissances PMax et PMin soit δP et Pmoy, δP étant un écart entre PMax et PMin.

Un convertisseur numérique analogique 161 permet de transformer ces informations de puissance en signaux analogiques qui sont appliqués aux entrées d'un circuit de commande en courant 162 de la diode laser.

Ce circuit de commande de laser 162 comprend une source de courant 163 et un circuit en amont permettant de moduler le courant de la diode laser en fonction des données émission.

Le dispositif peut également comporter des moyens de régulation de la température 204, 205 par effet Pelletier commandés par l'unité de traitement 153. Le signal est fourni par l'unité 153, converti par le convertisseur numérique-analogique 164, et appliqué à un amplificateur de puissance 204 qui le transmet à l'élément Pelletier 205.

On va décrire dans ce qui suit le fonctionnement d'un tel circuit appliqué à un système de transmission numérique sur fibre optique à l'alternat pour mieux comprendre l'invention.

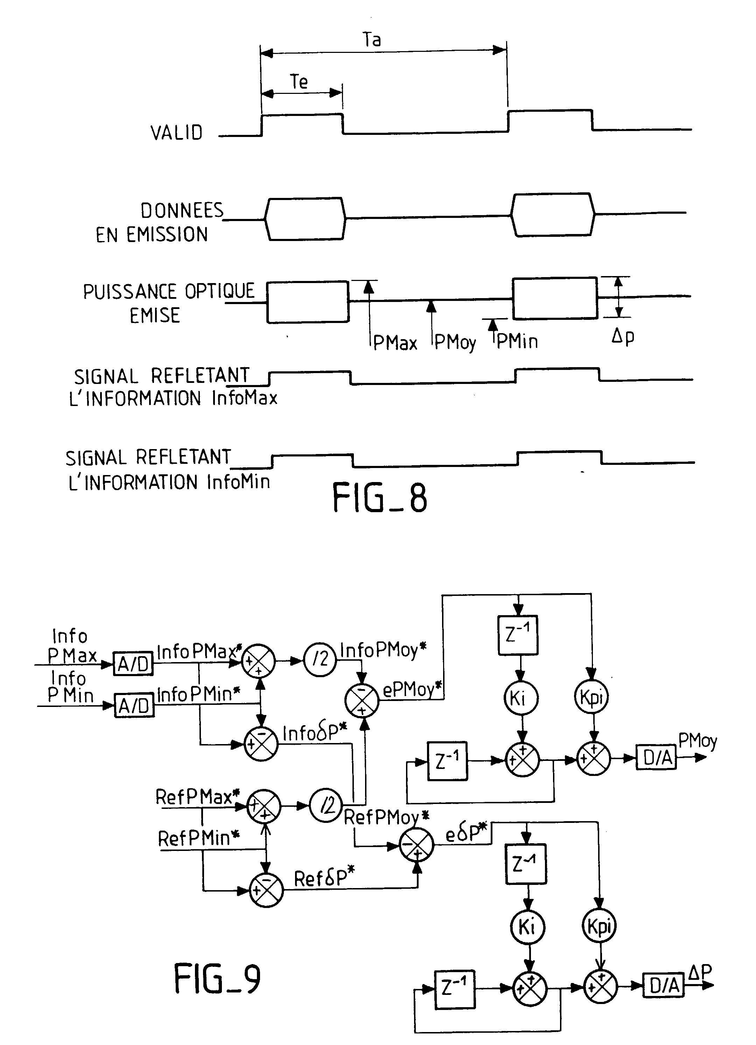

On rappelle que l'alternat est en fait un multiplexage dans le temps des deux sens de transmissions. Ce système de transmission permet de donner l'illusion parfaite d'un mode duplex intégral à l'utilisateur. Dans chaque sens l'information numérique à transmettre est mémorisée temporairement puis découpée en bloc et émise alternativement. On parle parfois de transmission "Ping Pong". Le débit instantané de la transmission de l'information à l'intérieur d'un bloc doit être supérieur à deux fois le débit réel du canal numérique résultant à transmettre afin de compenser l'effet des temps de propagation dans chaque sens. On peut se reporter pour mieux comprendre au schéma de la figure 7 qui illustre le principe de l'alternat. Une transmission par fibre optique est réalisée entre un système A et un système B. La durée Tp correspond au temps de propagation dans la fibre pour aller du système A au système B et vice versa.

La durée Te correspond au temps d'émission du bloc de donnée.

La durée Tg correspond au temps de garde du système distant.

La durée Ta correspond au temps de cycle du système.

On constate que l'émission de donnée du système A vers le système B s'effectue pendant la durée Te" et cela pendant Ta" comme cela a été représenté sur la figure 8. Afin de faciliter la réalisation du récepteur, la puissance émise par l'émetteur peut s'effectuer à trois niveaux :

- PMax pour un niveau "1 binaire".
- PMin pour un niveau "0 binaire".
- PMoy en absence de donnée.

Selon l'exemple de réalisation qui est décrit la photodiode 202 permet au composant d'élaborer deux informations reflétant le niveau de puissance maximum (valeur correspondant à l'émission d'une donnée à l'état0) et le niveau de puissance minimum (valeur correspondant à l'émission d'une donnée à l'état bas) émise par le laser sous forme d'une tension analogique tel que représenté sur la figure 6.

On choisit de préférence une photodiode présentant une courbe de réponse variant très peu avec la température de fonctionnement cette variation pouvant toute fois être modélisée et enregistrée en mémoire sous la forme d'une table de valeur de points de la courbe - caractéristique Y=f(T).

La diode laser permet d'être commandée à deux niveaux de manière à pouvoir régler les niveaux PMoy (puissance moyenne) et $\delta$P (puissance maximum-puissance minimum) sortant du laser.

Selon l'exemple d'application qui a été pris on émet un bloc d'information pendant "Ta" et cela toutes les "Ta" avec bien évidemment Te<Ta. Un signal VALID encadre les données émission (le signal VALID est à l'état 1 pendant Te''). La diode laser est asservie de telle manière qu'elle émet des niveaux de puissance constant au cours du temps. Le niveau PMoy est émis pendant l'absence de données. Les images des informations PMax et PMin produites par la photodiode ne sont disponibles que pendant l'émission des données (Cf figure 8).

Le signal VALID est utilisé pour interrompre le microprocesseur, celui-ci peut alors convertir les informations disponibles de la photodiode pour les utiliser dans l'algorithme d'asservissement chargé dans la mémoire de programme.

Le diagramme structurel de cet algorithme est représenté sur la figure 9. Le principe de l'algorithme est basé sur l'emploi de deux régulateurs discrets proportionnel - intégral pour pouvoir commander en PMoy et en $\delta$P la diode laser.

Le régulateur discret élabore une grandeur de commande discrète en fonction de l'écart de réglage discret obtenu entre l'information résultante de la photodiode et d'une référence fixée à une valeur bien définie. Ce régulateur est une combinaison d'un régulateur proportionnel et d'un régulateur intégrateur. La fonction qu'il remplit peut être définie à partir de la relation de base qui est donnée ci-dessous dans laquelle on a noté u*(k) la grandeur de commande discrète et e*(K) l'écart de réglage discret :

$$u*[K] = x*[k-1] + K_{pi}e*[k]$$

$$\text{avec} \quad x*[k-1] = K_i \sum_{j=0}^{k-1} e*[j]$$

$$= x*[k-2] + K_i e*[k-1]$$

Dans cette relation l'étoile signifie qu'il s'agit de valeurs discrètes (d'échantillons), k correspond aux nombres d'échantillons, K au facteur proportionnel, j à l'indice de variation des échantillons.

Sur le schéma de la figure 9 les blocs portant la mention A/D sont des convertisseurs analogiques numériques les blocs portant des indications "+ ou -" sont des additionneurs/soustracteurs, les blocs portant un trait de fraction sont des diviseurs les blocs portant un facteur $K_i$ où $KP_i$ sont des multiplieurs, les blocs portant la mention $Z^{-1}$ introduisent des retards sur les échantillons.

Les valeurs de commande discrètes qui sont élaborées selon cet exemple sont :
InfoPMax et InfoPmin
Les écarts de réglage discrets sont PMoy et $\delta$P.

L'algorithme de réglage qui est implanté dans le microprocesseur est donc le suivant :
Acquisition des informations InfoPMax et InfoPMin Evaluation de la commande PMoy :

```
| InfoPMoy=(InfoPMax+InfoPMin)/2                              |
| RefPMoy=(RefPMax+TabMax (T°)+RefPMin+TabMin(T°)/2           |
| eOldPMoy=ePMoy                                              |
| ePMoy=RefPMoy-InfoPMoy                                      |
| PMoy=Kpi.ePMoy+OldPMoy                                      |
| OldPMoy=eOldPMoy+Ki.eOldPMoy                                |
```

Evaluation de la commande δP :

```
| InfoδP=InfoPMax-InfoPMin                                    |
| RefδP=RefPMax+TabMax(T°)-RefPMin+TabMin(T°)                 |
| eOldδP=eδP                                                  |
| eδP=RefδP-InfoδP                                            |
| δP=Kpi.Eδp+OldδP                                            |
| OldδP=OldδP+Ki.eOldδP                                       |
```

La notation Old signifie l'ancienne valeur pour une information donnée par exemple eOldPMoy signifie l'ancienne valeur de l'écart de ePMoy.

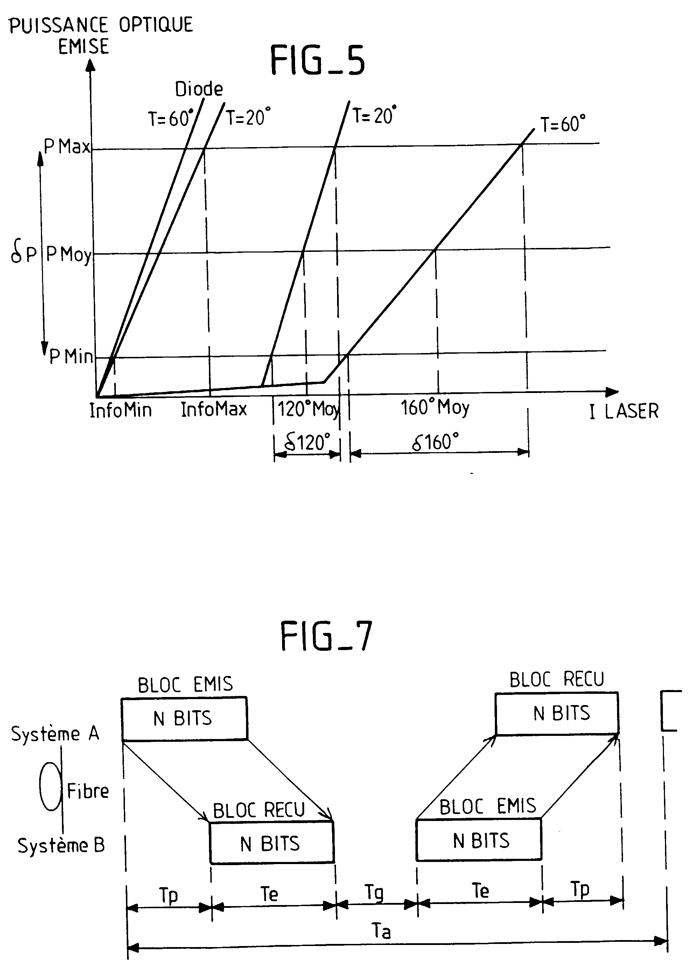

Conformément à l'invention les variations de la pente de la courbe caractéristique de la photodiode en fonction de la température du fonctionnement du laser sont pris en compte. Pour cela on considère les références RefPMax et RefPmin variables en fonction de la température dans l'algorithme. Bien entendu on aura au préalable modélisé cette courbe caractéristique qui a été représentée sur la figure 5 et qui va se trouver sous la forme d'une table chargée en mémoire.

En effet si on prend une température de 20° comme origine, un laser fonctionnant à 60° doit avoir une correction de δMax60° pour RefPMax et δMin60° pour RefPMin comme on peut le voir sur la figure 9. Connaissant la dérive de la pente en fonction de la température pour chaque tête laser on établit une table de correction en fonction de la température TabMax et TabMin. Ces tables peuvent être chargées ou téléchargées via le canal de communication, à chaque mise en service du composant.

Conformément à l'invention, le programme de gestion des alarmes va permettre d'indiquer la fin de vie du laser qui dépend de sa température de fonctionnement. Pour cela une alarme va être déclenchée par le composant lorsque le courant IMoy envoyé au laser dépassera une valeur IMaxMoy, qui dépend de la température, contenue dans la table TabMax.

Une alarme va être déclenchée pour indiquer un manque de puissance du laser lorsque le courant laser IMoy est inférieur à une valeur IMoyMin.

Une alarme va être déclenchée pour indiquer une température anormale du laser lorsque la température mesurée du laser est supérieure à une valeur TempMax.

Toutes les valeurs spécifiques du laser utilisées sont chargées dans le composant ou téléchargées via le canal de communication à la mise en fonction du composant.

L'algorithme correspondant à la génération des alarmes est le suivant :

```
|    si IMoyen>température Max(T°)                       |
|    alors alarme fin de vie du laser                   |
|    fin si                                             |
|    si IMoyen<IMoyenMin                                |
|    alors alarme manque puissance laser                |
|    fin si                                             |
|    si Température laser>TempératureMax            ..  |
|    alors alarme Température anormale du laser          |
|    fin si                                             |
```

Conformément à l'invention, la mémoire de programme comporte un programme pour réaliser une coupure de la diode laser. Le programme consiste à faire envoyer un courant minimum à la tête laser.

Conformément à l'invention, la mémoire de programme comporte un programme de commande pour déterminer la courbe caractéristique de la diode laser. Le programme consiste à arrêter l'émission de données, à envoyer successivement un courant constant au laser et à récupérer à travers la photodiode la puissance émise par le laser. Les résultats obtenus sont transmis par le canal de communication et permettent de réaliser la courbe caractéristique du laser.

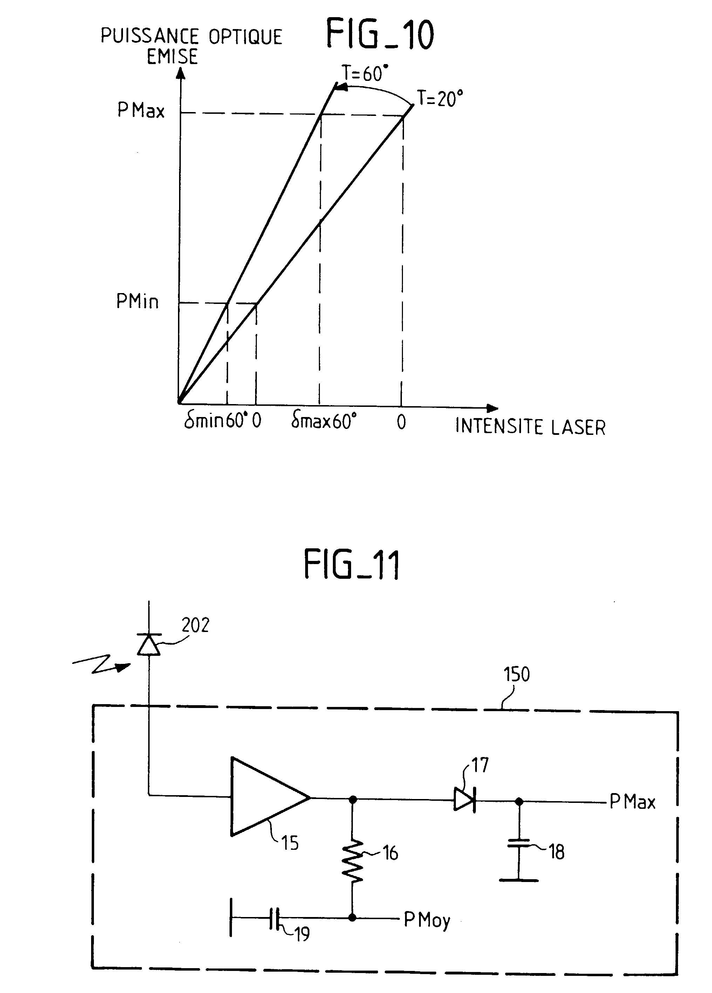

Sur la figure 11, on a représenté un exemple de réalisation du circuit 150 permettant d'obtenir une fonction du type $V=f(I)$. Selon cet exemple, le circuit 150 comprend un amplificateur transimpédance 15. La sortie PMax de cet amplificateur 15 est prise aux bornes d'un condensateur 18 à travers le passage dans une diode 17. La sortie PMoy est prise aux bornes d'un condensateur 19 à travers le passage dans une résistance 16.

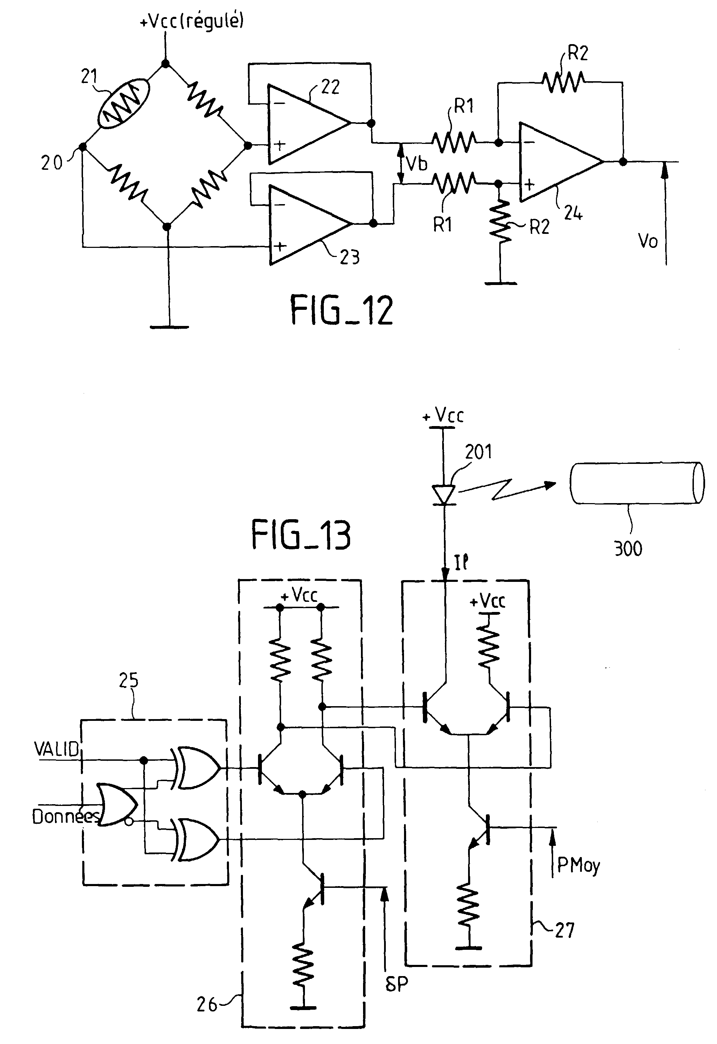

Sur la figure 12, on a représenté un exemple de réalisation du circuit 158 permettant d'obtenir une fonction du type $V=f(T°)$.

Le circuit 158 selon cet exemple comporte un pont de Wheatstone 20 incluant une thermistance 21. La tension Vb obtenue à la sortie des deux amplificateurs opérationnels 22 et 23 varie en fonction de la température. On obtient en sortie de ce circuit une tension Vo proportionnelle à la tension Vb. Cette tension Vo est prise à la sortie d'un amplificateur opérationnel 24 et est définie par la relation $VO=-Vb(R2/R1)$.

La figure 13, représente un exemple de réalisation du circuit 162.

Ce circuit comporte une circuit logique 25 et deux paires différentielles.

La première paire différentielle 26 permet de régler le niveau IMax - IMin du courant I$\ell$ à partir de $\delta$P. La deuxième paire différentielle 27 permet de régler le niveau IMoy de ce courant I$\ell$ à partir de PMoy.

D'autre part ce circuit 160 permet d'obtenir une référence de tension en interne. Cette référence de tension est utilisée pour les convertisseurs analogiques-numériques. Une telle référence de tension peut être obtenue au moyen d'un composant du commerce.

Ainsi selon l'invention, le dispositif comprend un organe de pilotage réalisé par un microprocesseur dans lequel la mémoire ROM ou EEPROM ou Flash EPROM contient le programme qui permet de gérer toutes les différentes fonctionnalités de la tête optique :

- calcul d'asservissement,
- gestion des alarmes (fin de vie du laser, température anormalement élevée, manque de puissance réception, coupure ligne...),
- coupure du laser,
- correction couplage à la fibre,
- gestion du canal de communication;

les informations stockées dans la mémoire Flash EPROM (ou EEPROM) permettent d'individualiser chaque tête laser utilisée. La mémoire Flash EPROM ayant la particularité de garder les informations même en cas d'absence d'alimentation, cela permet ainsi d'éviter de reconfigurer la tête laser après une coupure d'alimentation. Les informations stockées seront donc les suivantes :

- Références d'asservissement (permet de régler les niveaux de puissances lumineuses en sortie du laser).

7

- Paramètres du couplage fibre-laser (cette fonction ayant été modélisée).
- Paramètres de la variation de la courbe de réponse de la photodiode en fonction de la température.
- Paramètres alarmes (seuils de déclenchement des différentes alarmes).
- Paramètres de déclenchement de l'alarme fin de vie du laser en fonction de la température.

Il peut être prévu de choisir une Flash-EPROM d'assez grande capacité pour y stocker le programme principal (mise à part une petite partie correspondant au démarrage "boot" en terminologie anglo-saxonne) pour pouvoir faire des remises à jour du logiciel via le canal de communication.

**Revendications**

1.  Dispositif de contrôle de la puissance de sortie d'une diode laser susceptible d'être couplée à une fibre optique, comprenant:

    - une photodiode (202) permettant d'acquérir un signal caractéristique de la puissance émise par la diode laser;
    - des moyens numériques (100) de pilotage de la diode laser;
    - des moyens de mémorisation de programme de gestion d'alarme pour déclencher des alarmes dès détection d'une anomalie de fonctionnement,
    - des moyens de mémorisation de paramètres caractéristiques de la diode laser, de paramètres d'alarme,de paramètres de couplage de fibres,
    - un canal de communications permettant à l'unité de traitement d'émettre vers un centre de gestion ou de recevoir des informations d'un centre de gestion caractérisé en ce que les moyens numériques sont aptes à recevoir et à traiter le signal fourni par la phototodiode pour fournir un signal de commande en courant de manière à maintenir une puissance lumineuse de sortie de la diode laser constante, ces moyens comportant pour cela une unité centrale de traitement (153) associée à des moyens de mémorisation de programme de calcul d'asservissement, pour opérer un asservissement de la puissance de sortie à partir de deux niveaux de puissance émis par la diode laser et de deux niveaux de puissance de référence donnés par les paramètres caractéristiques de la diode laser enregistrés et pour maintenir une puissance de sortie constante, quels que soient la dérive et le changement de pente de la caractéristique de la diode laser en réponse au vieillissement ou à un changement de température ou à une perte de puissance due au couplage de cette diode à une fibre optique ou aux variations de la réponse de la photodiode en fonction de la température.

2.  Dispositif de contrôle selon la revendication 1, caractérisé en ce qu'il comporte des moyens de mémorisation de programme permettant de réaliser une coupure de la diode laser.

3.  Dispositif de contrôle selon la revendication 1, caractérisé en ce qu'il comporte des moyens de mémorisation de programme de commande pour déterminer la courbe caractéristique de la diode laser.

4.  Dispositif de contrôle selon la revendication 1, caractérisé en ce qu'il comporte des moyens d'acquisitions (150) des deux niveaux de puissance émis par la diode laser et des moyens de conversion analogique-numérique de ces deux niveaux de puissance.

5.  Dispositif de contrôle selon l'une quelconque des revendications précédentes, caractérisé en ce que le signal de commande en courant correspond à deux niveaux de puissance de sortie, en ce que le dispositif comporte en outre des moyens d'alimentation en courant (162) de la diode laser comportant deux entrées et des moyens de conversion numérique-analogique pour convertir les deux niveaux de puissance de sortie et les appliquer au moyen d'alimentation en courant.

6.  Dispositif de contrôle selon l'une quelconque des revendications précédentes, caractérisé en ce qu'il comporte des moyens de mesure (203) de la température ambiante régnant autour de la diode laser et des moyens de conversion analogique/numérique des mesures à effectuer pour les transmettre à l'unité de traitement.

7.  Dispositif de contrôle selon l'une quelconque des revendications précédentes, caractérisé en ce qu'il comporte des moyens de régulation de la température (204, 205) par effet Peltier commandés par l'unité de traitement.

8.  Dispositif de contrôle selon l'une quelconque des revendications précédentes, caractérisé en ce que les moyens de mémorisation de programme comprennent une mémoire à lecture (ROM ou EEPROM ou Flash EPROM), en

EP 0 583 186 B1

ce que les moyens de mémorisation de paramètre de référence (154) comprennent une mémoire programmable et effaçable électriquement (EEPROM).

**9.** Dispositif de contrôle selon l'une quelconque des revendications précédentes, caractérisé en ce que l'unité de traitement comporte un microprocesseur associé en outre à une mémoire de travail à lecture et écriture (RAM).

**10.** Dispositif de contrôle selon l'une quelconque des revendications 4-9, caractérisé en ce que les moyens d'acquisition des deux niveaux de puissance émise comporte un récepteur transimpédance.

**11.** Dispositif de contrôle selon l'une quelconque des revendications 5-10, caractérisé en ce que les moyens d'alimentation en courant comportent un amplificateur différentiel relié en sortie à une source de courant.

**12.** Dispositif selon l'une quelconque des revendications précédentes caractérisé en ce qu'il comprend un composant dans lequel les moyens numériques de pilotage de la diode laser sont formés par une seule puce de circuit intégré sur un substrat suivant une technologie bi-CMOS.

**13.** Dispositif selon l'une quelconque des revendications 1 à 11, caractérisé en ce qu'il comprend un composant hybride dans lequel les moyens numériques de pilotage de la diode laser, la diode laser et la photodiode sont formés par des puces de circuit intégré sur des substrats distincts.

## Patentansprüche

**1.** Vorrichtung zur Leistungsstabilisierung einer mit einer Lichtleitfaser gekoppelten Laserdiode, umfassend:

- eine Photodiode (202), die ermöglicht, ein Signal zu erfassen, das charakteristisch ist für die von der Laserdiode emittierte Leistung;
- digitale Steuereinrichtungen (100) der Laserdiode;
- Speichereinrichtungen für das Alarmverwaltungsprogramm, um Alarme auszulösen sobald eine Betriebsanomalie festgestellt wird,
- Speichereinrichtungen für Parameter, die charakteristisch sind für die Laserdiode, für Alarmparameter, für Fasernkopplungsparameter,
- eine Kommunikationsleitung, die der Verarbeitungseinheit ermöglicht, Daten an eine Verwaltungszentrale zu senden oder von einer Verwaltungszentrale zu erhalten,

**dadurch gekennzeichnet,**
daß die digitalen Einrichtungen das durch die Photodiode gelieferte Signal empfangen und verarbeiten können, um ein Stromsteuerungssignal zu liefern, so daß eine konstante Ausgangslichtleistung der Laserdiode aufrechterhalten wird, wobei diese Einrichtungen dazu eine zentrale Verarbeitungseinheit (153) enthalten, verbunden mit Speichereinrichtungen eines Regelungsberechnungsprogramms, um die Ausgangsleistung zu regeln aufgrund von zwei durch die Laserdiode emittierten Leistungspegeln bzw. -niveaus und zwei Bezugsleistungsniveaus, geliefert durch die eingespeicherten charakteristischen Parameter der Laserdiode, und um eine konstante Ausgangsleistung aufrechtzuerhalten, unabhängig von der Abweichung und der Veränderung der Steilheit der Kennlinie der Laserdiode als Reaktion auf die Alterung oder eine Temperaturänderung, oder verursacht durch die Kopplung dieser Diode mit einer Lichtleitfaser oder durch temperaturabhängige Veränderungen des Ansprechens der Photodiode.

**2.** Vorrichtung zur Stabilisierung nach Anspruch 1, dadurch gekennzeichnet, daß es Speichereinrichtungen eines Programms umfaßt, das ermöglicht, eine Abschaltung der Laserdiode zu bewirken.

**3.** Vorrichtung zur Stabilisierung nach Anspruch 1, dadurch gekennzeichnet, daß es Speichereinrichtungen eines Steuerprogramms zum Bestimmen der Kennlinie der Laserdiode umfaßt.

**4.** Vorrichtung zur Stabilisierung nach Anspruch 1, dadurch gekennzeichnet, daß es Einrichtungen zum Erfassen (150) der beiden durch die Laserdiode emittierten Leistungsniveaus umfaßt und Analog-Digital-Umwandlungseinrichtungen dieser beiden Leistungsnivaus.

**5.** Vorrichtung zur Stabilisierung nach einem der vorangehenden Ansprüche, dadurch gekennzeichnet, daß das Stromsteuerungssignal zwei Ausgangsleistungsniveaus entspricht, daß die Vorrichtung außerdem Stromversorgungseinrichtungen (162) der Laserdiode umfaßt, die zwei Eingänge aufweisen und Digital-Analog-Wandlungseinrichtungen, um die beiden Ausgangsleistungsniveaus zu konvertieren und an die Stromversorgungseinrichtungen zu legen.

6. Vorrichtung zur Stabilisierung nach einem der vorangehenden Ansprüche, dadurch gekennzeichnet, daß sie Meßeinrichtungen (203) der um die Laserdiode herum herrschenden Umgebungstemperatur umfaßt und Analog-Digital-Umwandlungseinrichtungen der durchzuführenden Messungen, um sie an die Verarbeitungseinheit zu übertragen.

7. Vorrichtung zur Stabilisierung nach einem der vorangehenden Ansprüche, dadurch gekennzeichnet, daß sie Einrichtungen (204, 205) zur Temperaturregelung mittels Peltiereffekt umfaßt, gesteuert durch die Verarbeitungseinheit.

8. Vorrichtung zur Stabilisierung nach einem der vorangehenden Ansprüche, dadurch gekennzeichnet, daß die programmspeichereinheiten einen Lesespeicher umfassen (ROM oder EEPROM oder Flash EPROM), daß die Bezugsparameter-Speichereinrichtungen (154) einen elektrisch programmier- und löschbaren Speicher umfassen (EPROM).

9. Vorrichtung zur Stabilisierung nach einem der vorangehenden Ansprüche, dadurch gekennzeichnet, daß die Verarbeitungseinheit einen Mikroprozessor umfaßt, der außerdem mit einem Lese- und Schreib-Arbeitsspeicher (RAM) verbunden ist.

10. Vorrichtung zur Stabilisierung nach einem der Ansprüche 4 bis 9, dadurch gekennzeichnet, daß die Erfassungseinrichtungen der beiden emittierten Leistungsniveaus einen Transimpedanz-Empfänger umfassen.

11. Vorrichtung zur Stabilisierung nach einem der Ansprüche 5 bis 10, dadurch gekennzeichnet, daß die Stromversorgungseinrichtungen einen mit dem Ausgang mit einer Stromquelle verbundenen Differentialverstärker umfassen.

12. Vorrichtung zur Stabilisierung nach einem der vorangehenden Ansprüche, dadurch gekennzeichnet, daß sie ein Bauteil umfaßt, bei dem die digitalen Steuereinrichtungen der Laserdiode in einem einzigen IC-Chip auf einem Substrat entsprechend einer Bi- bzw. Doppel-CMOS-Technik gebildet werden.

13. Vorrichtung zur Stabilisierung nach einem der Ansprüche 1 bis 11, dadurch gekennzeichnet, daß sie ein Hybridbauteil umfaßt, in dem die digitalen Steuereinrichtungen der Laserdiode, die Laserdiode und die Photodiode durch IC-Chips auf unterschiedlichen Substraten gebildet werden.

**Claims**

1. Device for controlling the output power of a laser diode designed to be coupled with an optical fibre, comprising:

   - a photodiode (202) enabling a signal characteristic of the power emitted by the laser diode to be acquired,
   - digital means (100) for controlling the laser diode,
   - means for storing in memory the alarm management system for triggering alarms when an operating anomaly is detected,
   - memory storage means for parameters characteristic of the laser diode, alarm parameters and coupling parameters of fibres,
   - a communications channel enabling the processing unit to transmit to a management centre or receive data from a management centre,

   characterised in that the digital means are designed to receive and process the signal supplied by the photodiode in order to provide a current control signal so as to maintain a constant luminous output power at the laser diode, these means having a central processing unit (153) for this purpose linked to means for storing in memory a control programme for operating a feedback control of the output power on the basis of two power levels emitted by the laser diode and two reference power levels provided by stored characteristic parameters of the laser diode and for maintaining a constant output power irrespective of the shift and change of curve of the characteristic of the laser diode in response to ageing, a change of temperature, a loss of power due to the coupling of this diode with an optical fibre or to the variations in the response of the photodiode as a function of temperature.

2.  Control device as claimed in claim 1, characterised in that it has memory means for storing a programme that will enable the laser diode to be disconnected.

3.  Control device as claimed in claim 1, characterised in that it has memory means for storing a control programme to determine the characteristic curve of the laser diode.

4.  Control device as claimed in claim 1, characterised in that it has means for acquiring (150) the two power levels emitted by the laser diode and means for analogue-to-digital conversion of these two power levels.

5.  Control device as claimed in any one of the preceding claims, characterised in that the current control signal corresponds to two output power levels and the device also has means for supplying current (162) to the laser diode comprising two inputs and digital-to-analogue convertor means for converting the two output power levels and applying them to the current supply means.

6.  Control device as claimed in any one of the preceding claims, characterised in that it has means for measuring (203) the ambient temperature prevailing around the laser diode and analogue-to-digital conversion means for the measurements to be taken in readiness for transmission to the processing unit.

7.  Control device as claimed in any one of the preceding claims, characterised in that it has means for controlling the temperature (204, 205) by the Peltier effect, controlled by the processing unit.

8.  Control device as claimed in any one of the preceding claims, characterised in that the programme memory storage means have a read only memory and the reference parameter memory storage means (154) have an electrically erasable reprogrammable memory.

9.  Control device as claimed in any one of the preceding claims, characterised in that the processing unit has a microprocessor which is linked in addition to a read and write working storage memory.

10. Control device as claimed in claims 4 to 9, characterised in that the means for acquiring the two emitted power levels has a transimpedance receiver.

11. Control device as claimed in claims 5 to 10, characterised in that the current supply means have a differential amplifier linked at its output to a current source.

12. Device as claimed in any one of the preceding claims, characterised in that it has a device in which the digital means for controlling the laser diode are formed by a single integrated circuit chip on a substrate consistent with a bi-CMOS technology.

13. Device as claimed in any one of claims 1 to 11, characterised in that it has a hybrid device in which the digital means for controlling the laser diode, the laser diode and the photodiode are formed by integrated circuit chips on separate substrates.

# FIG_1

HORLOGE →

DONNEES →

100

μp
+
cde Iℓ

Ip ←
T° ←
Iℓ →

200

202

201

300

CANAL DE
COMMUNICATION

# FIG_2

COMPOSANT  HYBRIDE

HORLOGE →

DONNEES →

101

Cde Iℓ

102

μp

Iℓ →

201

PUCE
LASER

Ip ←

202

PHOTODIODE

300

CANAL DE
COMMUNICATION

# FIG_3

PUISSANCE OPTIQUE EMISE

T=20°
C1

T=60°
C2

P à 20°

P à 60°

I CONSTANT

INTENSITE LASER

# FIG_4

PUISSANCE OPTIQUE EMISE

T= θ° (Laser neuf)

EFFET DU VIEILLISSEMENT

T=θ° (Laser fin de vie)

P EMISE CONSTANTE

I Max θ°

INTENSITE LASER

I LASER

FIG_5

FIG_7

PHOTODIODE
202

DIODE LASER
201

FIG_6
300

FIBRE OPTIQUE

205
ELEMENT PELTIER

203
Température

Données émission    Horloge émission

AMPLI DE PUISSANCE
204

Courant photodiode Ip

Courant laser Il

150
V = f(I)

Commande PELTIER

Commande laser
162
163

INFORMATION PUISSANCE EMISE
(Info PMax, PMin ou PCréte, PMoy)

Δp ou PMax

PMoyen ou PMin

164

157
Capteur de température

158
V = f(T°)

Information température

151          154          164        161          159        160
A/D    Références     D/A    D/A    A/D    Référence
       Asservissement                              tension

CALCUL D'ASSERVISSEMENT

Gestion Alarmes

Para-mètres alarmes
155

CANAL DE COMMUNICATION

CORRECTION COUPLAGE FIBRE

Para-mètres couplage fibre
156

COEUR DE MICROPROCESSEUR

153    100

Canal de communication    Alarmes

VALID

FIG_8

FIG_9

# FIG_10

PUISSANCE OPTIQUE
EMISE

P Max

PMin

δmin60° 0    δmax60°    0    INTENSITE LASER

T=60°    T=20°

# FIG_11

202

150

15

16

17

18

19

P Max

P Moy

FIG_12

FIG_13